Europäisches Patentamt

European Patent Office

Office européen des brevets

(11) Veröffentlichungsnummer: **0 640 986 A1**

## (12) EUROPÄISCHE PATENTANMELDUNG

(21) Anmeldenummer: 93113670.9

(51) Int. Cl.⁶: **G11C 29/00**, G06F 11/26

(22) Anmeldetag: **26.08.93**

(43) Veröffentlichungstag der Anmeldung:
**01.03.95 Patentblatt 95/09**

(84) Benannte Vertragsstaaten:
**AT DE FR GB IE IT NL**

(71) Anmelder: **SIEMENS AKTIENGESELLSCHAFT**
**Wittelsbacherplatz 2**
**D-80333 München (DE)**

(72) Erfinder: **Wirth, Norbert, Dipl.-Phys.**
**Mistralstrasse 4**
**D-85716 Unterschleissheim (DE)**
Erfinder: **Meyer, Willibald, Dipl.-Ing.**
**Annette-Kolb-Anger 15**
**D-81737 München (DE)**

(54) **Halbleiterspeicheranordnung und Verfahren zum Testen dieser Halbleiterspeicheranordnung.**

(57) Eine Halbleiterspeicheranordnung ist mit einer Modusauswahl-Einrichtung (17) und einer Impulswandler-Einrichtung (16) gebildet. Durch eine im Normalbetrieb nicht vorkommende Kombination von Zuständen der Speichersteuersignale ($\overline{CS}$, $\overline{RAS}$, $\overline{CAS}$, $\overline{WE}$) und einen Zustandswechsel eines Statusbits, das durch ein Adressbit A7 der externen Adresse ADD gegeben ist, wird die Frequenz des von einem Produktionstester stammenden externen Taktsignals CLK entweder verdoppelt oder unverändert gelassen. Dadurch ist ein Testen der Halbleiterspeicheranordnung bei interner doppelter Taktfrequenz mit herkömmlichen Produktionstestern möglich.

Fig 1

EP 0 640 986 A1

Die Erfindung betrifft eine Halbleiterspeicheranordnung mit einem in Reihen und Spalten organisierten Speicherzellenfeld, mit einem dem Speicherzellenfeld zugeordneten Reihenadressen-Decoder, mit einem dem Speicherzellenfeld zugeordneten Spaltenadressen-Decoder, mit einer mit dem Speicherzellenfeld und dem Spaltenadressen-Decoder verbundenen Datenübertragungseinrichtung, mit einer mit der Datenübertragungseinrichtung verbundenen Daten-Ein/Ausgabe Einrichtung, mit einer den Spaltenadressen-Decoder ansteuernden Adreßzähleinrichtung, und mit einem Zwischenspeicher für zumindest ein Adress-Signal, ein Reihenadress-Strobe-Signal, ein Spaltenadress-Strobe-Signal und ein Schreibfreigabesignal, der den Reihenadressen-Decoder, die Adreßzähleinrichtung und Daten-Ein/Ausgabe-Einrichtung ansteuert, wobei der Zwischenspeicher, die Adreßzähleinrichtung und die Daten-Ein/Ausgabe-Einrichtung von einem Taktsignal angesteuert sind, sowie ein Verfahren zum Testen dieser Halbleiterspeicheranordnung.

Eine derartige Halbleiterspeicheranordnung ist aus der EP 0 468 480 A2 bekannt und wird als synchrones DRAM oder SDRAM bezeichnet. Bezeichnend für ein solches SDRAM ist, daß die Eingabe von Adress-Signalen, das Auslesen und Einschreiben von Daten sowie das Erkennen der Zustände der Speichersteuersignale synchron mit einem Taktsignal ablaufen.
Beim Testen solcher SDRAM's treten Taktfrequenzen von über 100 MHz auf, beim sogenannten Page-Mode-DRAM liegen die Taktfrequenzen aber nur bei maximal 30 MHz. Die automatischen Produktionstester für DRAM's sind meist bis 60 MHz einsetzbar. Einige Testermodelle bieten zwar über Kanalmultiplex die gewünschte doppelte Taktrate, jedoch wird dann der Durchsatz bei der üblichen Parallelmessung halbiert, wodurch bei dieser Betriebsweise die Testkosten für SDRAM's verdoppelt würden. Die Anschaffungskosten von auf dem Markt erhältlichen 100 MHz-Testern erfordern Investitionen in Höhe mehrerer Millionen DM, wobei ein Testbetrieb oberhalb einer Taktfrequenz von 100 MHz auch mit diesen Geräten zu einer Halbierung des Durchsatzes führt.

Das der Erfindung zugrunde liegende Problem besteht somit darin, eine Halbleiterspeicheranordnung anzugeben, bei der mit handelsüblichen, für Page-Mode-DRAM's gebräuchlichen Produktionstestern ein Test mit effektiv doppelter Taktfrequenz durchgeführt werden kann.

Das Problem wird bei einer gattungsgemäßen Halbleiterspeicheranordnung dadurch gelöst, daß sie eine von Speichersteuersignalen und von einem externen Taktsignal ansteuerbare Modusauswahleinrichtung und eine von externen Taktsignal und der Modusauswahleinrichtung ansteuerbaren Impulswandler-Einrichtung, die das Taktsignal bereitstellt, aufweist. Das von der Impulswandler-Einrichtung abgegebene Taktsignal weist dabei abhängig von einer im Normalbetrieb nicht vorkommenden Kombination von Zuständen der Speichersteuersignale entweder dieselbe oder die doppelte Frequenz des externen Taktsignals auf. Das bedeutet, daß im Testbetrieb eine im Normalbetrieb nicht vorkommende Kombination von Speichersteuersignalen an die Modusauswahl-Einrichtung angelegt wird. Daraufhin erzeugt die Impulswandler-Einrichtung aus dem vom Produktionstester bereitgestellten externen Taktsignal ein Taktsignal mit doppelter Frequenz, so daß intern die Verarbeitung mit doppelter Geschwindigkeit abläuft.

Vorteilhaft ist es, wenn die im Normalbetrieb nicht vorkommenden Kombinationen von Zuständen der Speichersteuersignale zu definierten Zeitpunkten, beispielsweise bei einer ansteigenden Taktflanke des externen Taktsignals auftreten müssen.

Die Erfindung wird nachfolgend anhand von Ausführungsbeispielen mit Hilfe von Figuren näher erläutert. Dabei zeigen:

Figur 1    ein Blockschaltbild einer erfindungsgemäßen Halbleiterspeicheranordnung,

Figur 2    ein detailliertes Schaltbild für eine Modusauswahl-Einrichtung,

Figur 3    ein detailliertes Schaltbild für eine Impulswandler-Einrichtung,

Figur 4    ein Signalflußdiagramm für die Modusauswahl- und Impulswandler-Einrichtung, und

Figur 5    ein Signalflußdiagramm für einen Lesen-Schreiben-Lesen-Testbetrieb.

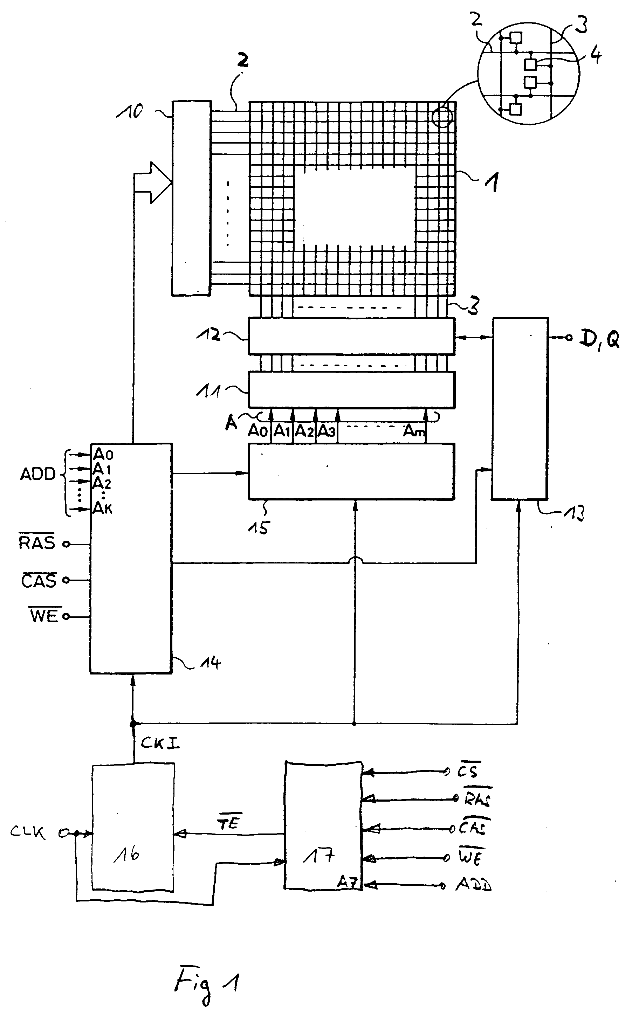

Figur 1 zeigt ein Speicherzellenfeld 1, das in Reihen 2 und Spalten 3 organisiert ist, wobei die Reihen 2 durch Wortleitungen und die Spalten 3 durch Bitleitungen gegeben sind. An den Überkreuzungen der Wort- mit den Bitleitungen sind Speicherzellen 4 angeordnet.

Dem Speicherzellenfeld 1 ist ein Reihenadressen-Decoder 10 zugeordnet, der mit den Wortleitungen verbunden ist. Ein Spaltenadressen-Decoder 11 ist über eine Datenübertragungseinrichtung 12 mit den Bitleitungen verbunden. Die Datenübertragungseinrichtung 12 ist zum Einschreiben und Auslesen von Daten D, Q aus dem Speicherzellenfeld 1 mit einer Daten-Ein/Ausgabe-Einrichtung 13 verbunden. Der Spaltenadressen-Decoder 11 wir von einer Adreßzähleinrichtung 15, die beispielsweise ein normaler Zähler sein kann, mit Adressen A, die aus Adressbits A0 bis Am bestehen, beaufschlagt.

Sowohl die externen Adressen ADD, die aus Adressbits A0 bis Ak bestehen, als auch das Reihenadress-Strobe-Signal $\overline{RAS}$, das Spaltenadress-

Strobe-Signal $\overline{CAS}$ und das Schreibfreigabesignal $\overline{WE}$ werden in einen Zwischenspeicher 14 eingelesen und dort zwischengespeichert, bis sie mit Hilfe eines Taktsignals CKI, mit dem der Zwischenspeicher 14 beaufschlagt ist, jeweils an den Reihenadressen-Decoder 10, die Adresszähleinrichtung 15, und die Daten-Ein/Ausgabe-Einrichtung 13 weitergeleitet werden. Sowohl der Reihenadressen-Decoder 10, die Adreßzähleinrichtung 15 als auch die Daten-Ein/Ausgabe-Einrichtung 13 sind zu diesem Zweck mit dem Zwischenspeicher 14 verbunden. Außerdem werden auch die Adreßzähleinrichtung 15 und die Daten-Ein/Ausgabe-Einrichtung 13 mit dem Taktsignal CKI beaufschlagt.

Das Taktsignal CKI wird von einer Impulswandler-Einrichtung 16 bereitgestellt. Diese wird sowohl von einem externen Taktsignal CLK als auch von einem Signal $\overline{TE}$ von einer Modusauswahl-Einrichtung 17 angesteuert. Dabei wird diese Modusauswahl-Einrichtung 17 ebenfalls von dem externen Taktsignal CLK und von den Speichersteuersignalen $\overline{CS}$, $\overline{RAS}$, $\overline{CAS}$, $\overline{WE}$, $\overline{ADD}$ beaufschlagt.

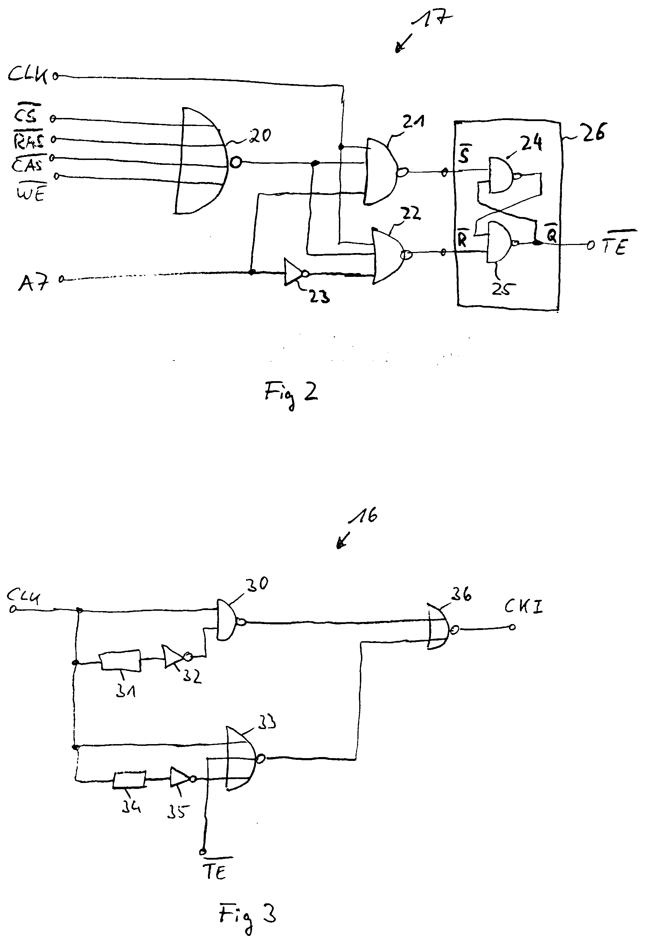

In Figur 2 ist ein detailliertes Schaltbild einer möglichen Realisierung einer erfindungsgemäßen Modusauswahl-Einrichtung 17 angegeben. Bei der dort gezeigten Schaltung werden das Chip-Auswahlsignal $\overline{CS}$, das Reihenadress-Strobe-Signal $\overline{RAS}$, das Spaltenadress-Strobe-Signal $\overline{CAS}$ und das Schreibfreigabesignal $\overline{WE}$ jeweils einem der vier Eingänge eines NOR-Gatters 20 zugeführt. Der Ausgang dieses NOR-Gatters 20 ist sowohl mit einem Eingang eines ersten NAND-Gatters als auch mit einem Eingang eines zweiten NAND-Gatters 22 verbunden. Das externe Taktsignal CLK wird sowohl einem Eingang des ersten NAND-Gatters 21 als auch einem Eingang des zweiten NAND-Gatters 22 zugeführt. Außerdem wird das erste NAND-Gatter 21 mit einem Adressbit A7 des Adress-Signals ADD und das zweite NAND-Gatter 22 mit dem mittels eines Inverters 23 invertierten Adressbit $\overline{A7}$ beaufschlagt. Der Ausgang des ersten NAND-Gatters 21 ist mit dem Set-Eingang $\overline{S}$ eines mit zwei NAND-Gattern 24, 26 gebildeten RS-Flip-Flops 26 verbunden. Der Ausgang des zweiten NAND-Gatters 22 ist mit dem Reset-Eingang $\overline{R}$ des RS-Flip-Flops 26 verbunden. Der Ausgang $\overline{Q}$ des Flip-Flops 26 bildet den Ausgang der Modusauswahl-Einrichtung 17 und stellt dessen Ausgangssignal $\overline{TE}$ bereit.

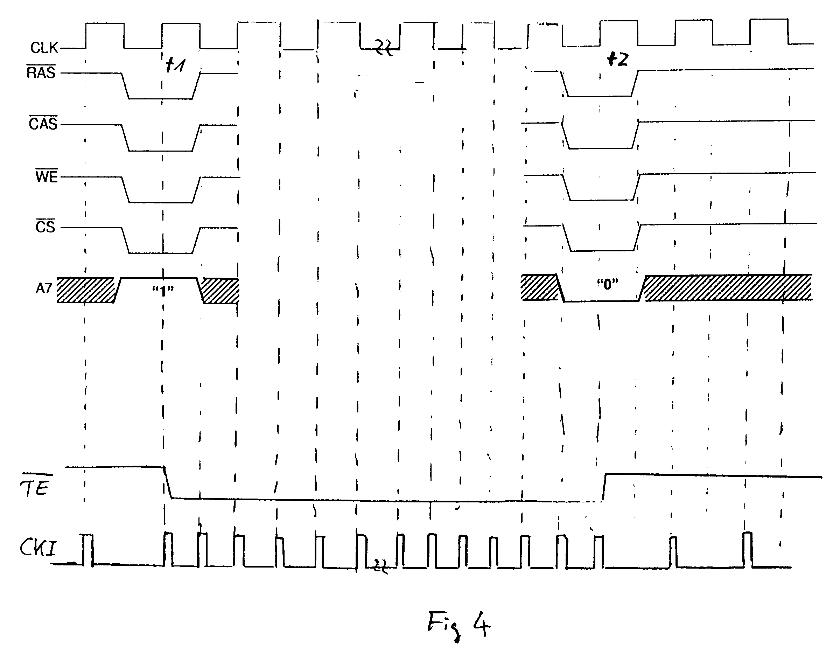

Das Signalflußdiagramm von Figur 4 zeigt die Funktion dieser Modusauswahl-Einrichtung 17. Wenn das Reihenadress-Strobe-Signal $\overline{RAS}$, das Spaltenadress-Strobe-Signal $\overline{CAS}$, das Schreibfreigabesignal $\overline{WE}$ und das Chip-Auswahlsignal $\overline{CS}$ einen Low-Zustand aufweisen und das Adressbit A7 des Adress-Signals ADD einen High-Zustand aufweist, geht das Ausgangssignal $\overline{TE}$ der Modusauswahl-Einrichtung 17 beim nächsten positiven Zustandswechsel des externen Taktsignals CLK zum Zeitpunkt t1 in einen Low-Zustand über. In äquivalenter Weise geht das Ausgangssignal $\overline{TE}$ der Modusauswahl-Einrichtung 17 bei gleichen Zuständen der Speichersteuersignale $\overline{RAS}$, $\overline{CAS}$, $\overline{WE}$, $\overline{CS}$ und bei einem Low-Pegel des Adressbits A7 beim ersten positiven Zustandswechsel des externen Taktsignals CLK zum Zeitpunkt t2 wieder in einen High-Zustand über. Durch eine definierte Kombination der Zustände der Speichersteuersignal $\overline{RAS}$, $\overline{CAS}$, $\overline{WE}$, $\overline{CS}$ läßt sich also durch den jeweiligen Zustand des Adreßbits A7 zu einem Zeitpunkt t1 oder t2, bei dem das externe Taktsignal CLK einen positiven Zustandswechsel aufweist, der Zustand des Ausgangssignals $\overline{TE}$ der Modusauswahl-Einrichtung 17 ändern. Es ist natürlich selbstverständlich, daß auch jede andere Kombination von Zuständen der Speichersteuersignale, die im Normalbetrieb nicht vorkommt, für die erfindungsgemäße Funktion verwendet werden kann. Die Modusauswahl-Einrichtung 17 muß dann entsprechend verändert werden, beispielsweise durch Vorschalten von Invertern vor die Eingänge des NOR-Gatters 20. Außerdem kann natürlich jedes beliebige Adressbit Ai oder definierte Kombinationen mehrerer Adressbits des Adress-Signals ADD als Statusbit oder Statusbits verwendet werden. Zudem kann die Umschaltung auch bei negativem Zustandswechsel des externen Taktsignals, beispielsweise durch Zwischenschalten eines Inverters erfolgen.

Ein Beispiel für eine Impulswandler-Einrichtung 16 zeigt Figur 3. Dort wird das externe Taktsignal CLK sowohl einem ersten Eingang eines NAND-Gatters 30 und einem ersten Eingang eines NOR-Gatters 33 als auch, jeweils über die Serienschaltung einer Verzögerungsschaltung 31 bzw. 34 und eines Inverters 32 bzw. 35 einem zweiten Eingang des NAND-Gatters 30 und einem zweiten Eingang des NOR-Gatters 33 zugeführt. Die Verzögerungsschaltungen 31, 34 können dabei beispielsweise durch die Serienschaltung einer geraden Anzahl von Invertern realisiert werden. Das Ausgangssignal $\overline{TE}$ der Modusauswahl-Einrichtung 17 wird einem dritten Eingang des NOR-Gatters 33 zugeführt. Die Ausgänge des NAND-Gatters 30 und des NOR-Gatters 33 sind jeweils mit einem Eingang eines weiteren NOR-Gatters 36 verbunden, dessen Ausgang das Taktsignal CKI bereitstellt.

Die Funktion dieser Impulswandler-Einrichtung 16 ist ebenfalls Figur 4 zu entnehmen. Wie dort zu erkennen ist, führt während eines Low-Zustands des Ausgangssignals $\overline{TE}$ der Modusauswahl-Einrichtung 17 jeder Zustandswechsel des Taktsignals CLK zu einem Impuls am Ausgang der Impulswandler-Einrichtung, während bei einem High-Zustand des Ausgangssignals $\overline{TE}$ der Modusauswahl-Einrichtung 17 nur positive Zustandswechsel des externen Taktsignals CLK zu einem Impuls des Taktsignals CKI führen. Das bedeutet also, daß durch einen Low-Zustand des Ausgangssignals $\overline{TE}$ der Modusauswahl-Einrichtung 17 die Frequenz des Taktsignals CKI verdoppelt wird.

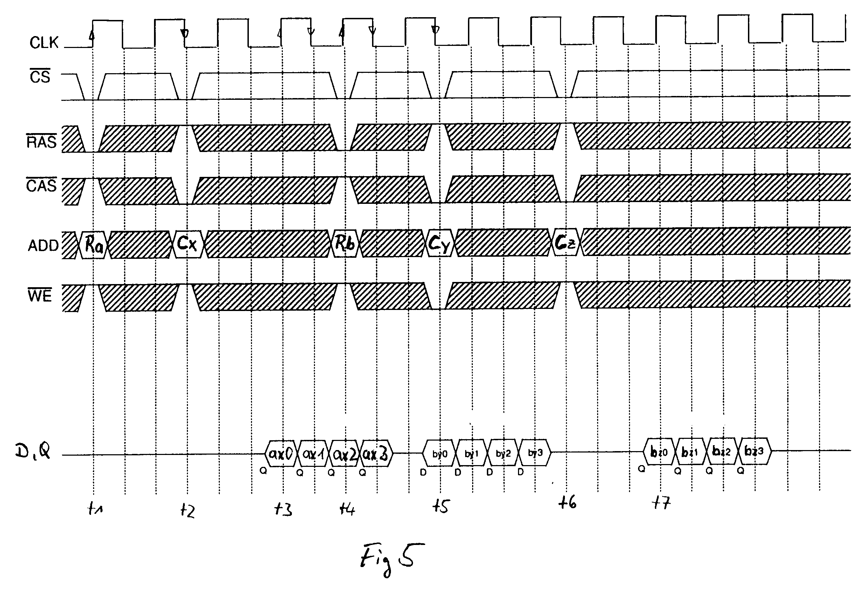

Ein Beispiel für eine mögliche Testbetriebsweise der Halbleiterspeicheranordnung gemäß Figur 1 zeigt das Signalflußdiagramm gemäß Figur 5. Zum Zeitpunkt t1 wird mit einer steigenden Taktflanke des externen Taktsignals CLK ein Reihenadress-Signal Ra und zum Zeitpunkt t2 mit einer fallenden Taktflanke ein Spaltenadress-Signal Cx übernommen, worauf zum Zeitpunkt t3 das Auslesen von Lesedaten ax0...ax3 mit aufeinanderfolgenden steigenden und fallenden Taktflanken erfolgen. Zum Zeitpunkt t4 wird ein neues Reihenadress-Signal Rb und zum Zeitpunkt t5 ein neues Spaltenadress-Signal Cy übernommen, wodurch ebenfalls zum Zeitpunkt t5 mit einem Low-Zustand des Schreibfreigabesignals $\overline{WE}$ das Schreiben von Schreibdaten by0...by3 beginnt. Zum Zeitpunkt t6 wird ein neues Spaltenadress-Signal Cz übernommen, was zum Zeitpunkt t7 zu einem Lesen von Lesedaten bz0...bz3 führt.

Durch die erfindungsgemäße Halbleiterspeicheranordnung und das erfindungsgemäße Verfahren zum Testen dieser Halbleiterspeicheranordnung ist es also möglich, bei jeder Taktflanke des externen Taktsignal CLK Adressen zu übernehmen und Daten zu lesen bzw. zu schreiben. Dadurch braucht das externe Taktsignal CLK eine nur halb so hohe Frequenz bei gleicher Datenrate aufzuweisen, so daß die Verwendung von herkömmlichen Produktionstestern bei SDRAM's möglich ist.

**Patentansprüche**

1. Halbleiterspeicheranordnung
   - mit einem in Reihen (2) und Spalten (3) organisierten Speicherzellenfeld (1),
   - mit einem dem Speicherzellenfeld (1) zugeordneten Reihenadressen-Decoder (10),
   - mit einem dem Speicherzellenfeld (1) zugeordneten Spaltenadressen-Decoder (11),
   - mit einer mit dem Speicherzellenfeld (1) und dem Spaltenadressen-Decoder (11) verbundenen Datenübertragungseinrichtung (12),
   - mit einer mit der Datenübertragungseinrichtung (12) verbundenen Daten-Ein/Ausgabe-Einrichtung (13),
   - mit einer den Spaltenadressen-Decoder (11) ansteuernden Adreßzähleinrichtung (15),
   - und mit einem Zwischenspeicher (14) für zumindest ein Adress-Signal (ADD), ein Reihenadress-Strobe-Signal ($\overline{RAS}$), ein Spaltenadress-Strobe-Signal ($\overline{CAS}$) und ein Schreibfreigabesignal ($\overline{WE}$), der den Reihenadressen-Decoder (10), die Adreßzähleinrichtung (15) und Daten-Ein/Ausgabe-Einrichtung (13) ansteuert,
   - wobei der Zwischenspeicher (14), die Adreßzähleinrichtung (15) und die Daten-Ein/Ausgabeeinrichtung (13) von einem Taktsignal (CKI) angesteuert sind,

   **gekennzeichnet durch**
   - eine von Speichersteuersignalen ($\overline{CS}$, $\overline{RAS}$, $\overline{CAS}$, $\overline{WE}$, ADD) und von einem externen Taktsignal (CLK) ansteuerbare Modusauswahl-Einrichtung (17) und
   - eine von dem externen Taktsignal (CLK) und der Modusauswahl-Einrichtung (17) ansteuerbare Impulswandler-Einrichtung (16), die das Taktsignal (CKI) bereitstellt.

2. Verfahren zum Testen einer Halbleiterspeicheranordnung gemaß Anspruch 1, **dadurch gekennzeichnet,** daß abhängig von im Normalbetrieb nicht vorkommenden Kombinationen von Zuständen der Speichersteuersignale ($\overline{CS}$, $\overline{RAS}$, $\overline{CAS}$, $\overline{WE}$, ADD) das von der Impulswandler-Einrichtung (16) abgegebene Taktsignal (CKI) entweder dieselbe oder die doppelte Frequenz des externen Taktsignal (CLK) aufweist.

3. Verfahren nach Anspruch 2, **dadurch gekennzeichnet,** daß die im Normalbetrieb nicht vorkommenden Kombinationen von Zuständen der Speichersteuersignale ($\overline{CS}$,$\overline{RAS}$,$\overline{CAS}$,$\overline{WE}$,ADD) zu definierten Zeitpunkten auftreten müssen.

Fig 1

Fig 2

Fig 3

Fig. 4

Fig 5

EP 0 640 986 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | EP-A-0 396 272 (KABUSHIKI KAISHA TOSHIBA) * Spalte 2, Zeile 21 - Spalte 3, Zeile 52 * <br><br>* Zusammenfassung; Anspruch 1; Abbildung 1 * <br>--- | 1-3 | G11C29/00 <br> G06F11/26 |
| A | EP-A-0 545 286 (HUGHES AIRCRAFT COMPANY) * Seite 2, Spalte 2, Zeile 37 - Seite 3, Spalte 3, Zeile 13 * * Seite 3, Spalte 4, Zeile 33 - Seite 4, Spalte 5, Zeile 47 * <br>--- | 1-3 | |
| A | IBM JOURNAL OF RESEARCH AND DEVELOPMENT Bd. 34, Nr. 2/3 , März 1990 , NEW YORK US Seiten 314 - 324 WONG R.C. 'An AC test structure for fast memory arrays' * Seite 315, Spalte 2, Zeile 17 - Seite 318, Spalte 2, Zeile 41; Abbildungen 1,2 * <br>----- | 1-3 | |
| | | | RECHERCHIERTE SACHGEBIETE (Int.Cl.6) |
| | | | G11C <br> G06F |

Der vorliegende Recherchenbericht wurde für alle Patentansprüche erstellt

| Recherchenort | Abschlußdatum der Recherche | Prüfer |
|---|---|---|
| DEN HAAG | 17. Februar 1994 | Sarasua Garcia, L |

EPO FORM 1503 03.82 (P04C03)